# EUROPEAN PATENT APPLICATION

(11) **EP 4 645 622 A1**
(43) Date of publication of application: **05.11.2025**
(21) Application number: 23910431.8
(22) Date of filing: 22.12.2023
(51) Int. Cl.: H02H 3/26

(54) **ELECTRIC LEAKAGE PROTECTION SYSTEM AND VEHICLE**

(30) Priority: 29.12.2022 CN 202211716536
(71) Applicant: BYD Company Limited, Shenzhen, Guangdong 518118 (CN)
(72) Inventor: YAN, Lei, Shenzhen, Guangdong 518118 (CN); CAO, Yangming, Shenzhen, Guangdong 518118 (CN); ZHANG, Junwei, Shenzhen, Guangdong 518118 (CN); LIU, Chuncheng, Shenzhen, Guangdong 518118 (CN); YUAN, Shuai, Shenzhen, Guangdong 518118 (CN)
(74) Representative: Mathys & Squire
(86) International application number: PCT/CN2023/141247
(87) International publication number: WO 2024/140505

(57) **Abstract**

An electric leakage protection system and a vehicle. The system comprises: a first Y capacitor and a second Y capacitor connected in series; a power battery, wherein a positive electrode of the power battery is connected to a first end of the first Y capacitor and the second Y capacitor which are connected in series, and a second end of the first Y capacitor and the second Y capacitor which are connected in series is separately connected to a negative electrode of the power battery and a negative electrode of a DC charging port; and a controller configured to: when acquired electric leakage-related parameters meet preset electric leakage protection conditions, control an energy leakage loop to avoid an electric shock.

## Description

### CROSS-REFERENCE TO RELATED APPLICATIONS

The present disclosure claims priority to and benefits of Chinese Patent Application No. 202211716536.4, filed on December 29, 2022 and entitled "ELECTRIC LEAKAGE PROTECTION SYSTEM AND VEHICLE". The entire content of the above-referenced disclosure is incorporated herein by reference.

### FIELD

The present disclosure relates to the field of vehicle technologies, and specifically, to an electric leakage protection system and a vehicle.

### BACKGROUND

With the rapid development of electric vehicles, requirements of users on vehicle charging performance gradually increase. Currently, common charging modes of electric vehicles include alternating current charging and direct current charging.

After a vehicle experiences electric leakage, if a user touches the direct current charging port and the vehicle body ground at the same time, quantity of electricity stored in a capacitor in the vehicle is discharged through the human body. Consequently, the user is at risk of electric shock, creating a potential safety hazard.

### SUMMARY

The present disclosure provides an electric leakage protection system and a vehicle, to resolve the foregoing technical problem.

A first aspect of embodiments of the present disclosure provides an electric leakage protection system, including:
a direct current charging port;
a charging port capacitor, a first end of the charging port capacitor being connected to a positive electrode of the direct current charging port, and a second end of the charging port capacitor being connected to a negative electrode of the direct current charging port;
a first Y capacitor and a second Y capacitor, the first Y capacitor being connected in series with the second Y capacitor, and a connection midpoint between the first Y capacitor and the second Y capacitor being connected to a vehicle body ground;
a power battery, a positive electrode of the power battery being connected to a first end of the first Y capacitor and the second Y capacitor which are connected in series, and a second end of the first Y capacitor and the second Y capacitor which are connected in series being separately connected to a negative electrode of the power battery and the negative electrode of the direct current charging port; and
a controller, the controller being configured to: control an energy leakage circuit when an obtained electric leakage related parameter satisfies a preset electric leakage protection condition, to avoid an electric shock, where the energy leakage circuit is formed by the second Y capacitor, the vehicle body ground, an external conductive member, the direct current charging port, and the charging port capacitor.

A second aspect of the embodiments of the present disclosure provides a vehicle, including the electric leakage protection system provided in the first aspect of the embodiments of the present disclosure.

According to the foregoing technical solution, the controller may determine, when the obtained electric leakage related parameter satisfies the preset electric leakage protection condition, that large quantity of electricity is stored in the first Y capacitor or the second Y capacitor. In this case, if the user touches the direct current charging port, the quantity of electricity stored in the first Y capacitor or the second Y capacitor is discharged through the human body, and consequently, the user receives an electric shock. To prevent the user from an electric shock, the energy leakage circuit may be controlled, to prevent the user from electric shock.

Other features and advantages of the present disclosure will be described in detail in the following detailed description part.

### BRIEF DESCRIPTION OF THE DRAWINGS

The accompanying drawings are intended to provide further understanding of the present disclosure and constitute a part of this specification. The accompanying drawings and the specific implementations below are used together for explaining the present disclosure rather than constituting a limitation to the present disclosure. In the accompanying drawings:
FIG. 1 is a schematic diagram of an electric leakage protection system according to an exemplary embodiment;
FIG. 2 is a schematic diagram of an electric leakage detection principle according to an exemplary embodiment;
FIG. 3 is a logical schematic diagram of a vehicle in a parking operation condition according to an exemplary embodiment;
FIG. 4 is a logical schematic diagram of a vehicle in a boost voltage direct current charging operation condition according to an exemplary embodiment;
FIG. 5 is a logical schematic diagram of a vehicle in a buck voltage direct current discharging operation condition according to an exemplary embodiment; and
FIG. 6 is a block diagram of a vehicle according to an exemplary embodiment.

### DETAILED DESCRIPTION

Specific implementations of the present disclosure are described in detail below with reference to the accompanying drawings. It will be understood that the specific implementations described herein are merely used to describe and explain the present disclosure, but are not intended to limit the present disclosure.

It should be noted that, in the present disclosure, all actions of obtaining a signal, information, or data are performed in accordance with the relevant data protection regulations and policies of the local country and with the authorization of the owner of a corresponding device.

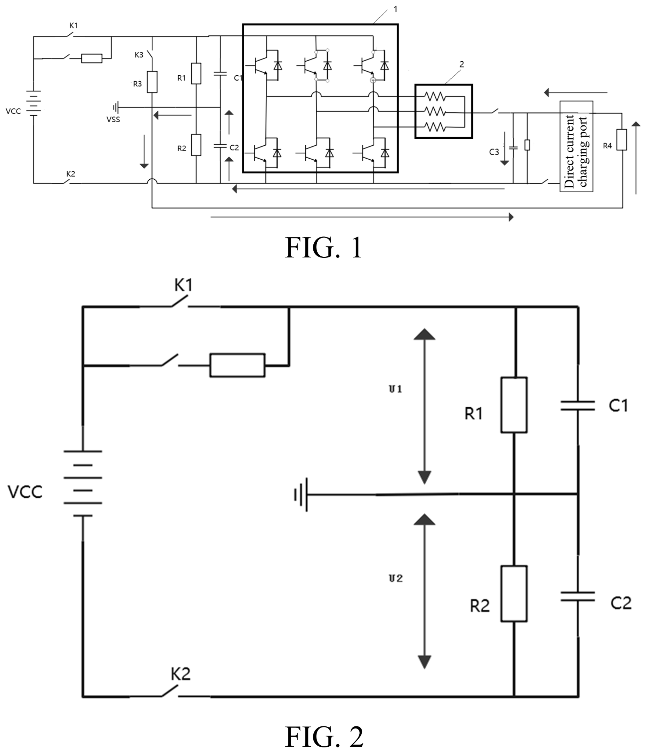

The present disclosure provides an electric leakage protection system. Referring to FIG. 1, the electric leakage protection system includes: a direct current charging port; a charging port capacitor C3, a first end of the charging port capacitor C3 being connected to a positive electrode of the direct current charging port, and a second end of the charging port capacitor C3 being connected to a negative electrode of the direct current charging port; a first Y capacitor C1 and a second Y capacitor C2, the first Y capacitor C1 being connected in series with the second Y capacitor C2, and a connection midpoint between the first Y capacitor C1 and the second Y capacitor C2 being connected to a vehicle body ground VSS; a power battery VCC, a positive electrode of the power battery VCC being connected to a first end of the first Y capacitor C1 and the second Y capacitor C2 which are connected in series, and a second end of the first Y capacitor C1 and the second Y capacitor C2 which are connected in series being separately connected to a negative electrode of the power battery VCC and the negative electrode of the direct current charging port; and a controller, the controller being configured to: control an energy leakage circuit when an obtained electric leakage related parameter satisfies a preset electric leakage protection condition, to avoid an electric shock, where the energy leakage circuit is formed by the second Y capacitor C2, the vehicle body ground VSS, an external conductive member R4, the direct current charging port, and the charging port capacitor C3.

For example, referring to FIG. 1, the first end of the charging port capacitor C3 is connected to the positive electrode of the direct current charging port, and the second end of the charging port capacitor C3 is connected to the negative electrode of the direct current charging port. In a process in which a vehicle performs boost voltage direct current charging, a charging pile charges the power battery through a charging port. However, a voltage required by the power battery is different from a voltage provided by the charging pile. In this case, the vehicle may inform the charging pile of the required charging voltage, the charging pile converts the charging voltage into the voltage required by the vehicle, to charge the charging port capacitor C3 with quantity of electricity, and then the charging port capacitor C3 charges the power battery VCC with quantity of electricity matching the power battery VCC. The positive electrode of the power battery VCC is connected to the first end of the first Y capacitor C1, the negative electrode of the power battery VCC is connected to the negative electrode of the direct current charging port, the second end of the second Y capacitor C2 is connected to a connection point between the negative electrode of the power battery VCC and the negative electrode of the direct current charging port, and the second end of the first Y capacitor C1 is connected to the first end of the first Y capacitor C1. The vehicle body ground VSS is connected to a connection point between the second end of the first Y capacitor C1 and the first end of the second Y capacitor C2. The vehicle body ground VSS may be understood as a conductive housing on the vehicle, for example, a vehicle housing or a floor inside the vehicle. One end of the external conductive member R4 is connected to the positive electrode of the direct current charging port, the other end of the external conductive member R4 is connected to the positive electrode of the power battery VCC by using a simulated electric leakage resistance, and the external conductive member R4 may be a simulated human body resistance.

Because a user is usually in contact with the vehicle body ground VSS, a whole vehicle insulation resistance such as a positive insulation resistance to ground R1 and a negative insulation resistance to ground R2 may be used to prevent a large current released by components such as the power battery VCC and a high-voltage part from being discharged to a human body through the vehicle body ground VSS. It can be understood that both the positive insulation resistance to ground R1 and the negative insulation resistance to ground R2 are insulation resistances between the component such as the power battery VCC and the high-voltage part on a vehicle simulated in the electric leakage protection system according to the present disclosure and the vehicle body ground VSS, and are used for isolating the component such as the power battery VCC and the high-voltage part from the vehicle body ground VSS, to prevent the large current released by the component such as the power battery VCC and the high-voltage part from being transmitted to the vehicle body ground VSS. In practice, the whole vehicle insulation resistance on the vehicle that isolates the power battery VCC from the vehicle body ground VSS includes not only the positive insulation resistance to ground R1 and the negative insulation resistance to ground R2.

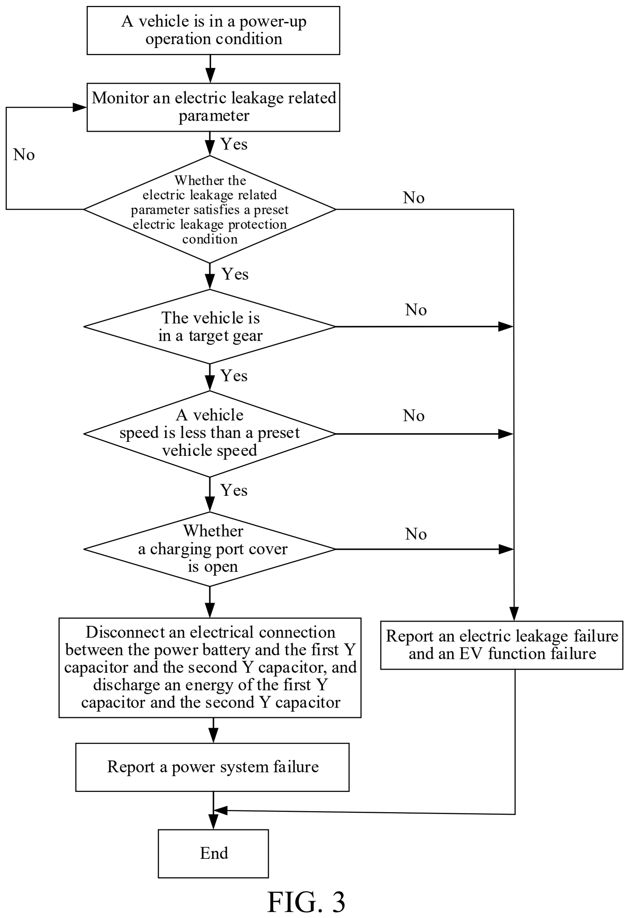

The present disclosure is a simulated electric leakage scenario, and provides an energy leakage circuit shown in FIG. 2 and FIG. 3. One end of a positive contact K1 is connected to one end of a simulated electric leakage switch K3, and the other end of the positive contact K1 is connected to the positive electrode of the power battery VCC. One end of a negative contact K2 is connected to the negative electrode of the VCC, and the other end of the negative contact K2 is connected to the external conductive member R4. When the positive contact K1 and the negative contact K2 are closed, the power battery VCC is conducted to the direct current charging port.

When the simulated electric leakage switch K3 is not closed, the positive insulation resistance to ground R1 and the negative insulation resistance to ground R2 bisect a voltage of the power battery VCC. For example, the power battery VCC generates a voltage of 500 V, and each of the positive insulation resistance to ground R1 and the negative insulation resistance to ground R2 may obtain 250 V. When the simulated electric leakage switch K3 is closed, a simulated electric leakage resistance R3 may simulate an electric leakage scenario of the power battery VCC. Because a resistance value of the simulated electric leakage resistance R3 is small, the positive electrode of the power battery VCC is directly connected to one end of the negative insulation resistance to ground R2, and the negative electrode of the power battery VCC is connected to one end of the negative insulation resistance to ground R2. Consequently, a voltage across the negative insulation resistance to ground R2 sharply increases to 500 V. In this case, a voltage difference between a first voltage and a second voltage changes from 0 to 500, and is greater than a preset voltage threshold. When the second voltage increases to 500 V, quantity of electricity stored in the second Y capacitor C2 connected to both ends of the negative insulation resistance to ground R2 also sharply increases.

In this case, if the user touches the positive electrode of the direct current charging port (the positive electrode is above the direct current charging port, and the negative electrode is below the direct current charging port in FIG. 2) and the vehicle body ground VSS at the same time, referring to arrows in FIG. 2, the energy leakage circuit is conducted. In this case, the quantity of electricity of the second Y capacitor C2 is discharged through the external conductive member R4 in the energy leakage circuit, that is, the quantity of electricity stored in the second Y capacitor C2 is discharged through the human body, the user has a risk of electric shock, and there is a potential safety hazard. The simulated human body resistance R4 is a resistance used for simulating a human body.

To perform electric leakage protection on the user and ensure user safety in a case of electric leakage of the whole vehicle, the present disclosure proposes to control the energy leakage circuit when the obtained electric leakage related parameter satisfies the preset condition, to prevent the user from an electric shock.

Referring to FIG. 2 and FIG. 3, the electric leakage related parameter includes a first voltage U1 of the first Y capacitor C1 and a second voltage U2 of the second Y capacitor C2; and the preset electric leakage protection condition is: a voltage difference between the first voltage and the second voltage being greater than a preset voltage threshold. The first voltage is a voltage across the positive insulation resistance to ground R1, and the second voltage is a voltage across the negative insulation resistance to ground R2. The preset voltage threshold may be 0, or may be another value. This is not limited in the present disclosure herein.

For example, when the voltage difference between the first voltage and the second voltage is greater than the preset voltage threshold, it indicates that quantity of electricity stored in the second Y capacitor C2 or the first Y capacitor C1 is large. In this case, if the user touches the direct current charging port, the quantity of electricity stored in the second Y capacitor C2 or the first Y capacitor C1 is discharged through the human body, and the user has a risk of electric shock. To prevent the user from having the risk of electric shock, when the voltage difference between the first voltage and the second voltage is greater than the preset voltage threshold, the energy leakage circuit may be controlled, to prevent the user from an electric shock.

The electric leakage related parameter includes a positive resistance value to ground and a negative resistance value to ground; and the preset electric leakage protection condition is: the positive resistance value to ground being different from the negative resistance value to ground.

For example, when the positive resistance value to ground of the positive insulation resistance to ground R1 is different from the negative resistance value to ground of the negative insulation resistance to ground R2, the voltage difference between the first voltage and the second voltage also changes, for example, changes from original 0 to being greater than the preset voltage threshold. In this case, large quantity of electricity is stored in the first Y capacitor C1 or the second Y capacitor C2, and if the user touches the direct current charging port, the quantity of electricity stored in the first Y capacitor C1 or the second Y capacitor C2 is discharged through the human body, and the user has a risk of electric shock. To prevent the user from having a risk of electric shock, when the positive resistance value to ground is different from the negative resistance value to ground, the energy leakage circuit may be controlled to prevent the user from an electric shock.

According to the foregoing technical solution, the controller may determine, when the obtained electric leakage related parameter satisfies the preset electric leakage protection condition, that large quantity of electricity is stored in the first Y capacitor C1 or the second Y capacitor C2. In this case, if the user touches the direct current charging port, the quantity of electricity stored in the first Y capacitor C1 or the second Y capacitor C2 is discharged through the human body, and consequently, the user has an electric shock. To prevent the user from an electric shock, the energy leakage circuit may be controlled, to prevent the user from an electric shock.

In a possible implementation, the controller may control the energy leakage circuit in the following two manners, to prevent the user from an electric shock.

Manner 1: Disconnect the energy leakage circuit when the obtained electric leakage related parameter satisfies the preset electric leakage protection condition, to avoid an electric shock.

Specifically, when the obtained electric leakage related parameter satisfies the preset electric leakage protection condition, a charging port cover is closed, and a connection between the external conductive member R4 and the direct current charging port is disconnected, to disconnect the energy leakage circuit.

When the vehicle has a function of closing the charging port cover, if the obtained electric leakage related parameter satisfies the preset electric leakage protection condition, the charging port cover may be closed, to prevent the external conductive member R4 from being in contact with the direct current charging port, thereby disconnecting the connection between the external conductive member R4 and the direct current charging port, and further disconnecting the energy leakage circuit, that is, causing the energy leakage circuit to be not conducted.

For example, if the obtained electric leakage related parameter satisfies the preset electric leakage protection condition, it is determined that the direct current charging port has an electric leakage risk. In this case, the charging port cover may be closed, to prevent the direct current charging port from being exposed to an external environment. Certainly, the human body may not touch the direct current charging port, thereby avoiding the risk of electric shock.

Manner 2: Control, when the obtained electric leakage related parameter satisfies the preset electric leakage protection condition, energy that is output by the energy leakage circuit to be less than a preset energy threshold, to avoid an electric shock.

Specifically, when the obtained electric leakage related parameter satisfies the preset electric leakage protection condition, an electrical connection between the power battery VCC and the first Y capacitor C1 and the second Y capacitor C2 is disconnected, and energy of the first Y capacitor C1 and the second Y capacitor C2 is discharged, to cause the energy that is output by the energy leakage circuit to the direct current charging port to be less than the preset energy threshold.

For example, when the obtained electric leakage related parameter satisfies the preset electric leakage protection condition, it is determined that the direct current charging port has an electric leakage risk. In this case, connections/a connection to the positive contact K1 and/or the negative contact K2 may be disconnected, to disconnect the electrical connection between the power battery VCC and the first Y capacitor C1 and the second Y capacitor C2, and prevent the power battery VCC from continuously leaking current to the direct current charging port. In addition, an electronic control 1 in FIG. 1 may be controlled to discharge most of energy generated by the first Y capacitor C1 or the second Y capacitor C2 to a motor 2, to consume quantity of electricity discharged by the second Y capacitor C2, so that energy discharged from the second Y capacitor C2 to the direct current charging port is greatly reduced. Certainly, even if the human body touches the direct current charging port, there is no risk of electric shock.

It can be understood that, the preset energy threshold is a protection threshold. In a case of being smaller than the preset energy threshold, even if the user touches the direct current charging port, there is no risk of electric shock. In a case of being greater than or equal to the preset energy threshold, the user may have a risk of electric shock.

According to the foregoing technical solution, the controller may control the charging port cover to be closed, to prevent the direct current charging port from being exposed to the external environment, and avoid contact between the external conductive member R4 and the direct current charging port from the source, thereby preventing the external conductive member R4 from an electric shock. The controller may further control the electrical connection between the power battery VCC and the first Y capacitor C1 and the second Y capacitor C2 to be disconnected, to prevent that the power battery VCC continuously leaks quantity of electricity to the second Y capacitor C2, and consume, by using the motor 2, quantity of electricity generated by the second Y capacitor C2, so that energy transmitted to the direct current charging port is less than the preset energy threshold, and even if the external conductive member R4 touches the direct current charging port, there is no risk of electric shock.

In a possible implementation, when the vehicle is in a target operation condition such as boost voltage direct current charging, buck voltage direct current discharging, a driving operation condition, and a parking operation condition, the external conductive member R4 may touch the direct current charging port, and consequently, the external conductive member R4 has an electric shock. Therefore, to prevent the external conductive member R4 from an electric shock, the present disclosure further includes the following multiple examples.

The target operation condition may be an operation condition in which the user may touch the direct current charging port.

The electric leakage protection system further includes: a motor 2, the motor 2 includes a multi-phase winding (for example, a three-phase winding shown in FIG. 1), first ends of the multi-phase winding being connected together and leading out an N line, and the N line being connected to the first end of the charging port capacitor C3; and an electronic control 1, the electronic control 1 includes a multi-phase bridge arm, a midpoint of each phase bridge arm being connected to a corresponding winding, first ends of the multi-phase bridge arm being connected together to form a first bus terminal, the first bus terminal being connected to the positive electrode of the power battery VCC, second ends of the multi-phase bridge arm being connected together to form a second bus terminal, and the second bus terminal being connected to the negative electrode of the power battery VCC. The controller is connected to the multi-phase bridge arm.

Referring to FIG. 1, a midpoint of each phase bridge arm is a connection point between an emitter of an upper NPN triode and a collector of a lower NPN triode in each group of NPN triodes; the first end (the first bus terminal) of the multi-phase bridge arm is an end to which collectors of multiple upper NPN triodes in the electronic control 1 are connected; and the second end (the second bus terminal) of the multi-phase bridge arm is an end to which emitters of multiple lower NPN triodes in the electronic control 1 are connected. The first bus terminal is connected to the positive electrode of the power battery VCC through the positive contact K1, and the second bus terminal is connected to the negative electrode of the power battery VCC through the negative contact K2.

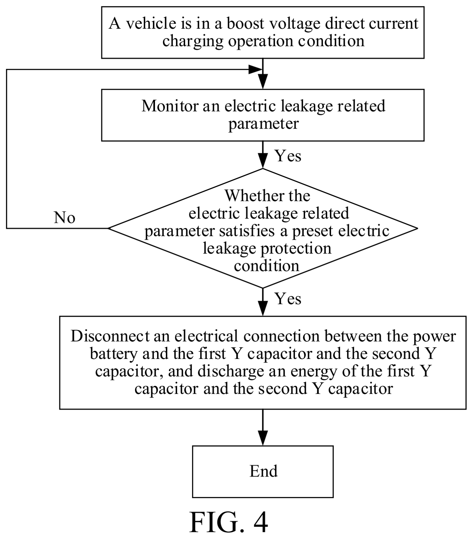

In some embodiments, the controller is configured to: control at least one phase bridge arm of the multi-phase bridge arm, to perform boost voltage direct current charging. Referring to FIG. 4, in a process of the boost voltage direct current charging, when the obtained electric leakage related parameter satisfies the preset electric leakage protection condition, the boost voltage direct current charging is stopped, the electrical connection between the power battery VCC and the first Y capacitor C1 and the second Y capacitor C2 is disconnected, and the energy of the first Y capacitor C1 and the second Y capacitor C2 is discharged, to cause the energy that is output by the energy leakage circuit to be less than the preset energy threshold.

In a process in which a charging connector performs boost voltage direct current charging on the power battery VCC by using the direct current charging port, the direct current charging port is exposed to the external environment, and an operator may touch the direct current charging port in a process in which the operator pulls out the charging connector or inserts the charging connector into the direct current charging port. In this case, if the obtained electric leakage related parameter satisfies the preset electric leakage protection condition, it indicates that the operator has a high risk of electric shock. To prevent the operator from an electric shock, the following actions may be performed.
(1) Stop boost voltage direct current charging on the power battery VCC; (2) Disconnect the electrical connection between the power battery VCC and the first Y capacitor C1 and the second Y capacitor C2; and (3) Discharge the energy of the first Y capacitor C1 and the second Y capacitor C2, to cause the energy that is output by the energy leakage circuit to the direct current charging port to be less than the preset energy threshold.

In a process of performing boost voltage direct current charging on the power battery VCC at the direct current charging port, if the power battery VCC has an electric leakage risk, quantity of electricity existing around the power battery VCC may be directly loaded to the second Y capacitor C2, so that quantity of electricity of the second Y capacitor C2 sharply increases. Similarly, quantity of electricity of the first Y capacitor C1 may also sharply increase. In this case, if the user touches the direct current charging port, energy of the first Y capacitor C1 or the second Y capacitor C2 is discharged to the human body through the energy leakage circuit. Therefore, by performing the foregoing action (1), the electronic control 1 may be prevented from continuously leaking a current that is output by the motor 2 to the power battery VCC, and the power battery VCC is prevented from continuously leaking a direct current to the second Y capacitor C2, so that quantity of electricity that is output by the second Y capacitor C2 can be gradually reduced; by performing the foregoing action (2), it can also be avoided that energy output by the power battery VCC is input to the second Y capacitor C2; and by performing the foregoing action (3), it causes energy output by the second Y capacitor C2 to the direct current charging port to be less than the preset energy threshold, and even if the user touches the direct current charging port, there is no risk of electric shock.

In a process of performing boost voltage alternating current charging on the power battery VCC at an alternating current charging port, the controller may further control the direct current charging port cover to be closed, to prevent the user from touching the direct current charging port when the power battery VCC is leaked, and the second Y capacitor C2 and the first Y capacitor C1 discharge energy to the direct current charging port.

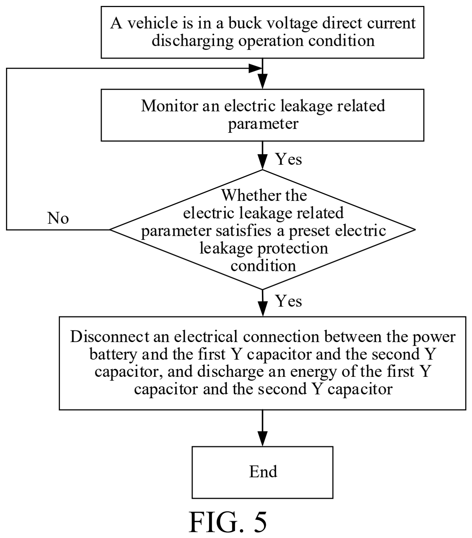

In some embodiments, the controller is further configured to: control at least one phase bridge arm of the multi-phase bridge arm, to perform buck voltage direct current discharging. Referring to FIG. 5, in a process of buck voltage direct current discharging, when the obtained electric leakage related parameter satisfies the preset electric leakage protection condition, the buck voltage direct current discharging is stopped, the electrical connection between the power battery VCC and the first Y capacitor C1 and the second Y capacitor C2 is disconnected, and the energy of the first Y capacitor C1 and the second Y capacitor C2 is discharged.

A buck voltage direct current discharging operation condition includes an external discharging operation condition of the whole vehicle or an intelligent charging operation condition. The external discharging operation condition of the whole vehicle refers to an operation condition in which the power battery VCC supplies power to an external electric device, for example, an external induction cooker of a vehicle, and the power battery VCC supplies power to the induction cooker. The intelligent charging function refers to an operation condition in which the power battery VCC charges a low-voltage battery, for example, the power battery VCC charges a low-voltage battery of 12 V with 500 V of high-voltage electricity.

In a process in which the power battery VCC performs buck voltage direct current discharging by using the direct current charging port, the direct current charging port is used as a discharging port of the vehicle, and the direct current charging port is exposed to an external environment. The user may touch the direct current charging port in a process in which the user pulls out a plug of an electrical appliance or inserts the plug of the electrical appliance into the direct current charging port. In this case, if the obtained electric leakage related parameter satisfies the preset electric leakage protection condition, it indicates that the user has a high risk of electric shock. To prevent the operator from an electric shock, the following actions may be performed.

(4) Stop external discharging of the power battery VCC; (5) Disconnect the electrical connection between the power battery VCC and the first Y capacitor C1 and the second Y capacitor C2; and (6) Discharge the energy of the first Y capacitor C1 and the second Y capacitor C2, to cause the energy that is output by the energy leakage circuit to the direct current charging port to be less than the preset energy threshold.

In a process of performing buck voltage direct current discharging on the power battery VCC, if the power battery VCC has an electric leakage risk, quantity of electricity existing around the power battery VCC may be directly loaded to the second Y capacitor C2, so that quantity of electricity of the second Y capacitor C2 sharply increases. Similarly, quantity of electricity of the first Y capacitor C1 may also sharply increase. In this case, if the user touches the direct current charging port, energy of the first Y capacitor C1 or the second Y capacitor C2 is discharged to the human body through the energy leakage circuit. Therefore, by performing the foregoing action (4), the power battery VCC may be prevented from continuously leaking a direct current to the second Y capacitor C2, so that quantity of electricity that is output by the second Y capacitor C2 can be gradually reduced; by performing the foregoing action (5), it can also be avoided that energy output by the power battery VCC is input to the second Y capacitor C2; and by performing the foregoing action (6), it causes energy output by the second Y capacitor C2 to the direct current charging port to be less than the preset energy threshold, and even if the user touches the direct current charging port, there is no risk of electric shock.

In a process in which the power battery VCC discharges through the alternating current charging port, the controller may further directly control the direct current charging port cover to be closed, to avoid the risk of electric shock when the user touches the direct current charging port.

In some embodiments, the controller is further configured to: close the charging port cover when a vehicle is in a driving operation condition.

When the vehicle is in the driving operation condition, the vehicle does not supply power to the outside through the direct current charging port, and the vehicle does not obtain external power through the direct current charging port. Therefore, to avoid the risk of electric shock of the user, when the vehicle is in the driving operation condition, the charging port cover may be directly controlled to be closed, so that the external conductive member R4 and the direct current charging port remain disconnected.

Specifically, in a case that the vehicle is in the driving operation condition, when the obtained electric leakage related parameter satisfies the preset electric leakage protection condition, the charging port cover is closed.

When the vehicle is in the driving operation condition, for example, when the vehicle is running at a low speed, if the obtained electric leakage related parameter satisfies the preset protection condition, it indicates that there is a risk of electric shock after the user touches the direct current charging port. In this case, the charging port cover of the direct current charging port may be controlled to be closed, to avoid, from the source, the risk of electric shock caused by the user touching the direct current charging port.

In some embodiments, the controller is configured to: when the vehicle is in a parking operation condition, and the obtained electric leakage related parameter satisfies the preset electric leakage protection condition, disconnect the electrical connection between the power battery VCC and the first Y capacitor C1 and the second Y capacitor C2, and discharge the energy of the first Y capacitor C1 and the second Y capacitor C2.

Referring to FIG. 3, the vehicle is determined to be in the parking operation condition when the vehicle is in a power-up operation condition, the vehicle is in a target gear, a vehicle speed is less than a preset vehicle speed, and a charging port is in an open state; or the vehicle is determined to be in the parking operation condition when the vehicle is in a power-up driving operation condition, the vehicle is in the target gear, and the vehicle speed is less than the preset vehicle speed.

The target gear includes a parking gear or a neutral gear. When the vehicle is in the parking gear or the neutral gear, it indicates that the vehicle may stop running, and only in this case, the user has a probability of touching the charging port; and when the vehicle is in a non-parking gear or the neutral gear, it indicates that the vehicle is running, and in this case, the user cannot touch the charging port on the running vehicle.

It can be understood that, when the vehicle is in the parking gear or the neutral gear, the vehicle may have a low speed, for example, the vehicle is coasting. To further determine whether the vehicle stops running or is coasting, the vehicle speed may be determined. When the vehicle speed is less than the preset vehicle speed (for example, 5 km/h), it indicates that the vehicle will stop running, and the user has a probability of touching the direct current charging port of the vehicle. In this case, if the obtained electric leakage related parameter satisfies the preset electric leakage protection condition, the electrical connection between the power battery VCC and the first Y capacitor C1 and the second Y capacitor C2 may be disconnected, and the energy of the first Y capacitor C1 and the second Y capacitor C2 is discharged. When the vehicle speed is greater than or equal to the preset vehicle speed, it indicates that the vehicle is in a coasting state. In this case, the user cannot touch the direct current charging port on the vehicle that is in the coasting state. Therefore, the electrical connection between the power battery VCC and the first Y capacitor C1 and the second Y capacitor C2 does not need to be disconnected, and the energy of the first Y capacitor C1 and the second Y capacitor C2 does not need to be discharged.

It can be understood that, in the parking operation condition, only when the vehicle is in the target gear, and the vehicle speed is less than the preset vehicle speed, the electrical connection between the power battery VCC and the first Y capacitor C1 and the second Y capacitor C2 may be disconnected, and the energy of the first Y capacitor C1 and the second Y capacitor C2 may be discharged; and merely when the vehicle speed is less than the preset vehicle speed, the electrical connection between the power battery VCC and the first Y capacitor C1 and the second Y capacitor C2 cannot be disconnected, and the energy of the first Y capacitor C1 and the second Y capacitor C2 cannot be discharged.

The reason is: when the vehicle starts in a forward gear (a non-target gear), the vehicle may be starting, and there is a stage in which the vehicle speed is less than the preset vehicle speed. In this case, if the electrical connection between the power battery VCC and the first Y capacitor C1 and the second Y capacitor C2 is directly disconnected when the vehicle speed is less than the preset vehicle speed, the vehicle cannot start smoothly.

Therefore, in a case that the power battery VCC leaks, when the vehicle is in a target gear such as a parking gear or a neutral gear, the vehicle speed is less than the preset vehicle speed, and it is determined that the vehicle is parking, the electrical connection between the power battery VCC and the first Y capacitor C1 and the second Y capacitor C2 may be disconnected, and the energy of the first Y capacitor C1 and the second Y capacitor C2 is discharged, to ensure normal running of the vehicle.

In any implementation of the present disclosure, when there is a charging port cover detection function on the vehicle, the charging port cover detection function may be enabled to detect the charging port cover when the obtained electric leakage related parameter satisfies the preset electric leakage protection condition, the vehicle is in the target gear, and the vehicle speed of the vehicle is less than the preset vehicle speed. If the charging port cover is in an open state, the electrical connection between the power battery VCC and the first Y capacitor C1 and the second Y capacitor C2 is disconnected, and the energy of the first Y capacitor C1 and the second Y capacitor C2 is discharged. If the charging port cover is in a closed state, the electrical connection between the power battery VCC and the first Y capacitor C1 and the second Y capacitor C2 does not need to be disconnected, and the energy of the first Y capacitor C1 and the second Y capacitor C2 does not need to be discharged, to keep the charging port cover in the closed state.

When there is no charging port cover detection function on the vehicle, the charging port cover does not need to be detected. When the obtained electric leakage related parameter satisfies the preset electric leakage protection condition, the vehicle is in the target gear, and the vehicle speed of the vehicle is less than the preset vehicle speed, the electrical connection between the power battery VCC and the first Y capacitor C1 and the second Y capacitor C2 is directly disconnected, and the energy of the first Y capacitor C1 and the second Y capacitor C2 is discharged.

Certainly, the vehicle may further output a warning signal when the obtained electric leakage related parameter satisfies the preset electric leakage protection condition, to prompt the user that the vehicle has an electric leakage risk.

In any embodiment of the present disclosure, if the obtained electric leakage related parameter does not satisfy the preset electric leakage protection condition, the electric leakage related parameter is continued to be monitored, and the energy leakage circuit is controlled only when the electric leakage related parameter satisfies the preset electric leakage protection condition, to avoid an electric shock.

According to the foregoing technical solution, when the vehicle is in the target operation condition such as the driving operation condition, the parking operation condition, the boost voltage direct current charging operation condition, and the buck voltage direct current discharging operation condition, if it is detected that the electric leakage related parameter satisfies the preset electric leakage protection condition, it indicates that there is a risk of electric shock after the user touches the direct current charging port. In this case, the charging port cover may be controlled to be closed, and/or the electrical connection between the power battery VCC and the first Y capacitor C1 and the second Y capacitor C2 is controlled to be disconnected, and the energy of the first Y capacitor C1 and the second Y capacitor C2 is discharged, to prevent the user from an electric shock.

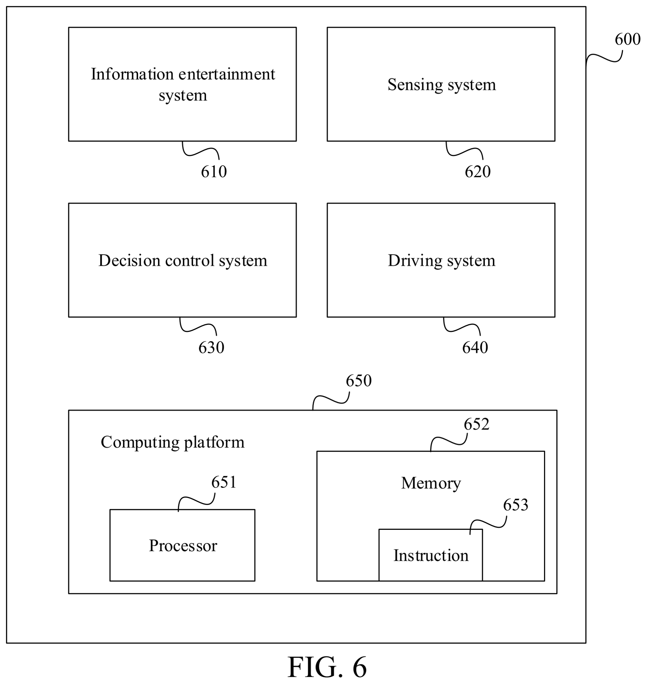

FIG. 6 is a block diagram of a vehicle 600 according to an exemplary embodiment. For example, the vehicle 600 may be a hybrid vehicle, or may be a non-hybrid vehicle, an electric vehicle, a fuel cell vehicle, or another type of vehicle. The vehicle 600 may be an autonomous driving vehicle, a semi-autonomous driving vehicle, or a non-autonomous driving vehicle.

Referring to FIG. 6, the vehicle 600 may include various subsystems, such as an information entertainment system 610, a sensing system 620, a decision control system 630, a driving system 640, and a computing platform 650. The vehicle 600 may further include more or fewer subsystems, and each subsystem may include multiple components. In addition, each subsystem and each component of the vehicle 600 may be interconnected in a wired or wireless manner.

In some embodiments, the information entertainment system 610 may include a communication system, an entertainment system, a navigation system, and the like.

The sensing system 620 may include several sensors, configured to sense surrounding environment information of the vehicle 600. For example, the sensing system 620 may include a global positioning system (the global positioning system may be a GPS^{®} system, a BeiDou^{®} system, or another positioning system), an inertial measurement unit (inertial measurement unit, IMU), a laser radar, a millimeter-wave radar, an ultrasonic radar, and a camera device.

The decision control system 630 may include a computation system, a whole vehicle control unit, a steering system, an accelerator, and a braking system.

The driving system 640 may include a component that provides power for the vehicle 600 to move. In an embodiment, the driving system 640 may include an engine, an energy source, a drive system, and a wheel. The engine may be one or a combination of more of an internal engine, an electric motor, and an air compression engine. The engine can convert energy provided by the energy source into mechanical energy.

Some or all functions of the vehicle 600 are controlled by the computing platform 650. The computing platform 650 may include at least one processor 651 and a memory 652. The processor 651 may execute an instruction 653 stored in the memory 652.

The processor 651 may be any conventional processor, such as a commercially available CPU. The processor may further include, for example, a graphic process unit (Graphic Process Unit, GPU), a field programmable gate array (Field Programmable Gate Array, FPGA), a system on chip (System on Chip, SOC), an application-specific integrated circuit (Application-Specific Integrated Circuit, ASIC), or a combination thereof.

The memory 652 can be implemented by any type of volatile or non-volatile storage devices or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic disk, or an optical disc.

In addition to the instruction 653, the memory 652 may further store data, such as a road map, route information, a position, a direction, a speed, and other vehicle data. The data stored in the memory 652 may be used by the computing platform 650.

In this embodiment of the present disclosure, the processor 651 may execute the instruction 653, to complete all or some steps of the foregoing electric leakage protection system. The preferred implementations of the present disclosure are described in detail above with reference to the accompanying drawings. However, the present disclosure is not limited to the specific details in the foregoing implementations, multiple simple deformations may be made to the technical solution of the present disclosure within a range of the technical concept of the present disclosure, and these simple deformations fall within the protection scope of the present disclosure.

It should be additionally noted that, the specific technical features described in the foregoing specific implementations may be combined in any proper manner in a case without conflict, and to avoid unnecessary repetition, various possible combinations are not otherwise explained in the present disclosure.

In addition, different implementations of the present disclosure may also be arbitrarily combined without departing from the idea of the present disclosure, and these combinations shall still be regarded as content disclosed in the present disclosure.

## Claims

1. An electric leakage protection system, comprising:
a direct current charging port;
a charging port capacitor, a first end of the charging port capacitor being connected to a positive electrode of the direct current charging port, and a second end of the charging port capacitor being connected to a negative electrode of the direct current charging port;
a first Y capacitor and a second Y capacitor, the first Y capacitor being connected in series with the second Y capacitor, and a connection midpoint between the first Y capacitor and the second Y capacitor being connected to a vehicle body ground;
a power battery, a positive electrode of the power battery being connected to a first end of the first Y capacitor and the second Y capacitor which are connected in series, and a second end of the first Y capacitor and the second Y capacitor which are connected in series being separately connected to a negative electrode of the power battery and the negative electrode of the direct current charging port; and
a controller, the controller being configured to: control an energy leakage circuit when an obtained electric leakage related parameter satisfies a preset electric leakage protection condition, to avoid an electric shock, wherein the energy leakage circuit is formed by the second Y capacitor, the vehicle body ground, an external conductive member, the direct current charging port, and the charging port capacitor.

2. The electric leakage protection system according to claim 1, wherein the electric leakage related parameter comprises a first voltage of the first Y capacitor and a second voltage of the second Y capacitor; and
the preset electric leakage protection condition is: a voltage difference between the first voltage and the second voltage being greater than a preset voltage threshold.

3. The electric leakage protection system according to claim 1 or 2, wherein the electric leakage related parameter comprises a positive resistance value to ground and a negative resistance value to ground; and
the preset electric leakage protection condition is: the positive resistance value to ground being different from the negative resistance value to ground.

4. The electric leakage protection system according to any one of claims 1 to 3, wherein the controller is configured to: disconnect the energy leakage circuit when the obtained electric leakage related parameter satisfies the preset electric leakage protection condition, to avoid an electric shock.

5. The electric leakage protection system according to any one of claims 1 to 4, wherein the controller is configured to: close a charging port cover and disconnect a connection between the external conductive member and the direct current charging port when the obtained electric leakage related parameter satisfies the preset electric leakage protection condition, to disconnect the energy leakage circuit.

6. The electric leakage protection system according to any one of claims 1 to 5, wherein the controller is configured to: control, when the obtained electric leakage related parameter satisfies the preset electric leakage protection condition, energy that is output by the energy leakage circuit to be less than a preset energy threshold, to avoid an electric shock.

7. The electric leakage protection system according to any one of claims 1 to 6, wherein the controller is configured to: disconnect, when the obtained electric leakage related parameter satisfies the preset electric leakage protection condition, an electrical connection between the power battery and the first Y capacitor and the second Y capacitor, and discharge energy of the first Y capacitor and the second Y capacitor, to cause the energy that is output by the energy leakage circuit to be less than the preset energy threshold.

8. The electric leakage protection system according to any one of claims 1 to 7, further comprising:
a motor (2), the motor (2) comprises a multi-phase winding, first ends of the multi-phase winding being connected together and leading out an N line, and the N line being connected to the first end of the charging port capacitor; and
an electronic control (1), the electronic control (1) comprises a multi-phase bridge arm, a midpoint of each phase bridge arm being connected to a corresponding winding, first ends of the multi-phase bridge arm being connected together to form a first bus terminal, the first bus terminal being connected to the positive electrode of the power battery, second ends of the multi-phase bridge arm being connected together to form a second bus terminal, and the second bus terminal being connected to the negative electrode of the power battery; and
the controller being connected to the multi-phase bridge arm, and the controller being configured to: control at least one phase bridge arm of the multi-phase bridge arm, to perform boost voltage direct current charging.

9. The electric leakage protection system according to any one of claims 1 to 8, wherein the controller is further configured to: in a process of the boost voltage direct current charging, when the obtained electric leakage related parameter satisfies the preset electric leakage protection condition, stop the boost voltage direct current charging, disconnect an electrical connection between the power battery and the first Y capacitor and the second Y capacitor, and discharge the energy of the first Y capacitor and the second Y capacitor, to cause the energy that is output by the energy leakage circuit to be less than the preset energy threshold.

10. The electric leakage protection system according to any one of claims 1 to 9, wherein the controller is further configured to close the charging port cover when a vehicle is in a driving operation condition.

11. The electric leakage protection system according to claim 8, wherein the controller is further configured to control at least one phase bridge arm of the multi-phase bridge arm, to perform buck voltage direct current discharging.

12. The electric leakage protection system according to any one of claims 1 to 11, wherein the controller is further configured to: in a process of the buck voltage direct current discharging, when the obtained electric leakage related parameter satisfies the preset electric leakage protection condition, stop the buck voltage direct current discharging, disconnect an electrical connection between the power battery and the first Y capacitor and the second Y capacitor, and discharge the energy of the first Y capacitor and the second Y capacitor.

13. The electric leakage protection system according to any one of claims 1 to 12, wherein the controller is configured to: when the vehicle is in a parking operation condition, and the obtained electric leakage related parameter satisfies the preset electric leakage protection condition, disconnect the electrical connection between the power battery and the first Y capacitor and the second Y capacitor, and discharge the energy of the first Y capacitor and the second Y capacitor.

14. A vehicle, comprising: the electric leakage protection system according to one of claims 1 to 13.
